**Europäisches Patentamt**

(19) **European Patent Office**

**Office européen des brevets**

(11) Numéro de publication: **0 113 633**
**B1**

(12) # FASCICULE DE BREVET EUROPEEN

(45) Date de publication du fascicule du brevet:
11.03.87

(51) Int. Cl.⁴: **G 03 B 41/00**

(21) Numéro de dépôt: **83402543.9**

(22) Date de dépôt: **27.12.83**

(54) **Procédé et dispositif d'alignement optique de motifs dans deux plans rapprochés dans un appareil d'exposition comprenant une source de rayonnement divergent.**

(30) Priorité: **30.12.82 FR 8222080**

(43) Date de publication de la demande:
**18.07.84 Bulletin 84/29**

(45) Mention de la délivrance du brevet:
**11.03.87 Bulletin 87/11**

(84) Etats contractants désignés:
**DE GB IT NL**

(56) Documents cités:
**EP - A - 0 010 998**
**FR - A - 2 392 421**
**GB - A - 2 073 950**
**US - A - 4 037 969**
**US - A - 4 292 576**

(73) Titulaire: **THOMSON-CSF, 173, Boulevard Haussmann, F-75379 Paris Cedex 08 (FR)**

(72) Inventeur: **Fay, Bernard, THOMSON-CSF SCPI 173, bld Haussmann, F-75379 Paris Cedex 08 (FR)**

(74) Mandataire: **Lepercque, Jean et al, THOMSON-CSF SCPI 19, avenue de Messine, F-75008 Paris (FR)**

## Description

L'invention se rapporte à la fabrication de circuits par microlithographie et a plus particulièrement pour objet un procédé d'alignement optique de masques et d'échantillons situés dans des plans rapprochés.

La fabrication de circuits intégrés implique la réalisation sur un substrat ou échantillon de fenêtres permettant de localiser l'implantation ou le traitement. Ce substrat est recouvert d'une couche de résine photosensible. Cette réalisation de fenêtres se fait par masquage de cette résine à partir d'un masque. Il a été utilisé comme méthode de transfert le contact direct ou la proximité et plus récemment la technique de transfert par projection optique.

Bien que la méthode de transfert par proximité soit plus ancienne, celle-ci reste d'actualité lorsqu'on utilise comme source d'énergie radiante, par exemple une source émettant dans la gamme des rayons X.

En effet, dans les dispositifs de reproduction de masques par ombre portée utilisant une source de rayonnement de haute énergie: rayons X, électrons, ions; on peut reproduire des motifs de dimensions bien inférieures au micromètre, jusqu'au dixième de micromètre, tout en préservant une distance de séparation des plans du masque et de l'échantillon de plusieurs micromètres, ce afin d'éviter tout contact, source de dégradation. Dans ces conditions, les effets de diffractions photoniques ou corpusculaires sont négligeables.

Par suite de l'absence d'éléments optiques formateurs d'image, le pouvoir de résolution de ces systèmes est indépendant des dimensions du champ utile couvert, ce qui permet d'envisager la fabrication de circuits microniques et submicroniques par projection de masques de grande surface: diamètre de 100 mm ou plus, et donc de parvenir à de très fortes cadences de production pour de tels circuits.

Dans les dispositifs de reproduction de motifs mettant en œuvre cette technique, un échantillon est soumis à des expositions d'un rayonnement X ou plus généralement soumis à des expositions d'un rayonnement d'énergie radiantes à travers un masque convenable situé à quelques micromètres de l'échantillon. Chaque opération nécessite un alignement précis du masque et de l'échantillon. Pour obtenir cet alignement avec une précision de l'ordre du dizième de micromètres plusieurs procédés d'alignement utilisant les propriétés de diffraction de la lumière par des réseaux ont été décrits, par exemple la méthode des franges de Moiré, ou les méthodes de Torii et de Smith. Ces méthodes consistent à inscrire sur le masque et sur l'échantillon des réseaux de pas déterminés et à détecter le rayonnement diffracté par ces deux réseaux situés dans des plans rapprochés.

Toutes ces méthodes laissent subsister une indétermination due à la périodicité du signal détecté et il est alors nécessaire de lever l'incertitude par une autre méthode.

Pour pallier ces inconvénients, il a été proposé dans le brevet EP-B 0 010 998, un procédé d'alignement de deux plans rapprochés et le dispositif d'alignement mettant en œuvre ce procédé, permettant d'éviter les inconvénients des procédés susmentionnés et permettant en particulier d'obtenir un alignement avec une grande précision de deux plans rapprochés, et de tolérer, sans perte de précision d'alignement, des variations d'espacement des deux plans plus grandes que dans les procédés d'alignement antérieurement connus.

Pour cela, une lentille à zones de Fresnel linéaires est inscrite sur le masque et un trait, de largeur supérieure ou égale à la largeur de la plus petite zone de Fresnel inscrite sur le masque, est inscrit sur l'échantillon. L'éclairement du masque par faisceau de lumière monochromatique parallèle, laser par exemple, permet de former sur l'échantillon une tache d'éclairement rectangulaire (foyer) correspondant à l'ordre de diffraction +1 qui lorsqu'elle recouvre le trait repère formé sur l'échantillon conduit à détecter un maximum ou un minimum d'éclairement du rayonnement réfléchi par l'échantillon suivant que le repère inscrit sur cet échantillon est plus ou moins réfléchissant que la zone qui l'entoure.

Ce procédé permet d'aligner entre eux, dans de bonnes conditions, tous les points de zones de diamètre maximum typiquement égal à 10 mm pour des largeurs de trait descendant jusqu'à la valeur 0,2 micromètres. Plus généralement le diamètre maximum de zone permissible correspond à environ $10^5$ points de résolution. Ceci ne permet pas de profiter de toutes les possibilités qu'offre le procédé de reproduction par ombre portée et qui ont été rappelées.

Cette limitation est essentiellement due aux distorsions dimensionnelles relatives qui se produisent inévitablement lorsqu'on augmente les dimensions du masque et corrélativement du substrat puisque le transfert s'effectue avec un grandissement 1/1.

Sauf à diviser le masque et l'échantillon en zones élémentaires à aligner individuellement, il n'est donc pas possible d'utiliser un masque d'un diamètre de 100 mm ou plus, d'un seul tenant, pour la largeur de trait précédemment définie.

L'utilisation de masques de grandes dimensions serait cependant possible si on pouvait disposer de moyens de compensation des distorsions dimensionnelles relatives du masque et de la plaquette de semi-conducteur après chaque étape du processus de fabrication de circuits, ceci afin de garantir l'alignement précis de tous les motifs sur la totalité du champ à couvrir.

C'est le but que se fixe l'invention.

A cette fin, l'invention propose un procédé d'alignement précis de deux plans rapprochés de grande surface utile permettant de compenser les distorsions linéaires relatives des deux plans et le dispositif d'alignement mettant en œuvre ce procédé.

L'invention a donc pour objet un procédé d'alignement optique de motifs dans deux plans rapprochés dans un appareil d'exposition comportant une source de rayonnement divergent disposée à une distance du premier plan; les motifs présentant des distorsions dimensionnelles relatives; procédé comprenant:

– une étape préliminaire d'inscription de trois couples de motifs repères disposés sur deux axes orthogonaux et se coupant en un point (O) situé dans une région centrale des motifs à aligner, les motifs repères de chaque couple inscrits sur le premier plan étant formés d'au moins une lentille à zones de Fresnel linéaires alternativement opaques et transparentes, lesdites zones s'étendant parallèlement à l'axe sur lequel la lentille est disposé, et des motifs repères réfléchissants inscrits sur le second plan et comportant une zone centrale parallèle à l'axe correspondant, la zone centrale de ce motif repère étant en outre gravée pour former un réseau de phase réflecteur de pas constant s'étendant parallèlement à cet axe;

– une étape pendant laquelle les deux plans sont placés parallèlement l'un par rapport à l'autre à un écart déterminé;

– une étape d'alignement suivant lesdits deux axes orthogonaux et en rotation autour d'un axe orthogonal aux deux plans et interceptant la source de rayonnement divergent; cette étape d'alignement consistant en des opérations d'éclairements, par un faisceau lumineux monochromatique parallèle, de chaque lentille à zones de Fresnel linéaires de manière à former dans le second plan un trait lumineux ayant sensiblement les mêmes dimensions que la zone centrale des motifs inscrits sur ce plan, de détection d'une fraction du rayonnement réfléchi par ce second plan et émergeant d'une lentille à zones à Fresnel linéaires, de déplacement de deux plans l'un part rapport à l'autre jusqu'à ce que le rayonnement détecté passe par un extremum correspondant à l'alignement du couple de motifs repères et à répéter ces opérations pour tous les autres couples de motifs repères; ladite source à rayonnement divergent formant sur le second plan l'image du motif du premier plan par ombre projetée avec un grandissement G obéissant à la relation G = $\frac{e}{D}$, dans laquelle e est l'écart déterminé entre les deux plans et D la distance séparant la source du premier plan; caractérisé en ce qu'en outre il comprend:

– une seconde étape préliminaire consistant à inscrire sur deux axes orthogonaux se coupant un point d'intersection des axes sur lesquels sont inscrits les couples de motifs de repères d'alignement, au moins deux couples de motifs repères supplémentaires de nature identique aux repères d'alignement, les motifs repères de chaque couple, s'étendant suivant une direction auxdits deux axes;

– une étape ultérieure à l'étape d'alignement pour déterminer les distorsions dimensionnelles des deux motifs consistant en des opérations d'éclairement par un faisceau lumineux monochromatique parallèle de chaque lentille à zones de Fresnel linéaires des couples de motifs repères supplémentaires de manière à former dans le second plan un trait lumineux ayant sensiblement les mêmes dimensions que la zone centrale des motifs inscrits sur ce plan, de détection d'une fraction du rayonnement réfléchi par ce second plan et émergeant d'une lentille à zones de Fresnel linéaires, de déplacement des deux plans, l'un par rapport à l'autre, jusqu'à ce que le rayonnement détecté passe par un extremum correspondant à l'alignement du couple de motifs repères de mémorisation du déplacement effectué en signe et en amplitude, à répéter ces opérations pour tous les autres couples de motifs supplémentaires et à déterminer à partir des valeurs de déplacements successifs une grandeur de correction;

– et une étape d'ajustement dudit grandissement G à partir de la grandeur de correction pour obtenir une compensation des distorsions dimensionnelles relatives.

L'invention a encore pour objet un dispositif de mise en œuvre d'un procédé.

L'invention sera mieux comprise et d'autres caractéristiques apparaîtront à l'aide de la description qui suit en référence aux figures annexées:

– la fig. 1 représente un exemple de dessins inscrits sur le masque et l'échantillon pour l'alignement;

– les fig. 2 et 3 représentent des schémas explicatifs du fonctionnement du dispositifs d'alignement;

– les fig. 4 à 6 représentent des exemples de dispositifs optiques utilisables pour isoler le rayonnement de retour réfléchi par l'échantillon du rayonnement ambiant et réaliser l'alignement selon deux axes orthogonaux dans un plan et en rotation autour d'un axe normal au plan;

– les fig. 7 et 8 illustrent schématiquement les phénomènes de distorsions dimensionnelles relatives entre un masque et un échantillon;

– la fig. 9 illustre un exemple de disposition selon une première variante utilisée pour évaluer l'endistorsion selon l'invention;

– les fig. 10 à 12 illustrent une seconde variante selon l'invention;

– la fig. 13 illustre schématiquement un dispositif de mise en œuvre du procédé de l'invention;

– la fig. 14 illustre une variante de réalisation de ce dispositif;

– la fig. 15 illustre l'application du dispositif de l'invention dans un appareil d'exposition à rayon X de type automatique.

L'invention reprenant certaines des dispositions décrites dans le brevet EP-B 0 010 998, il paraît tout d'abord utile d'en rappeler les caractéristiques principales.

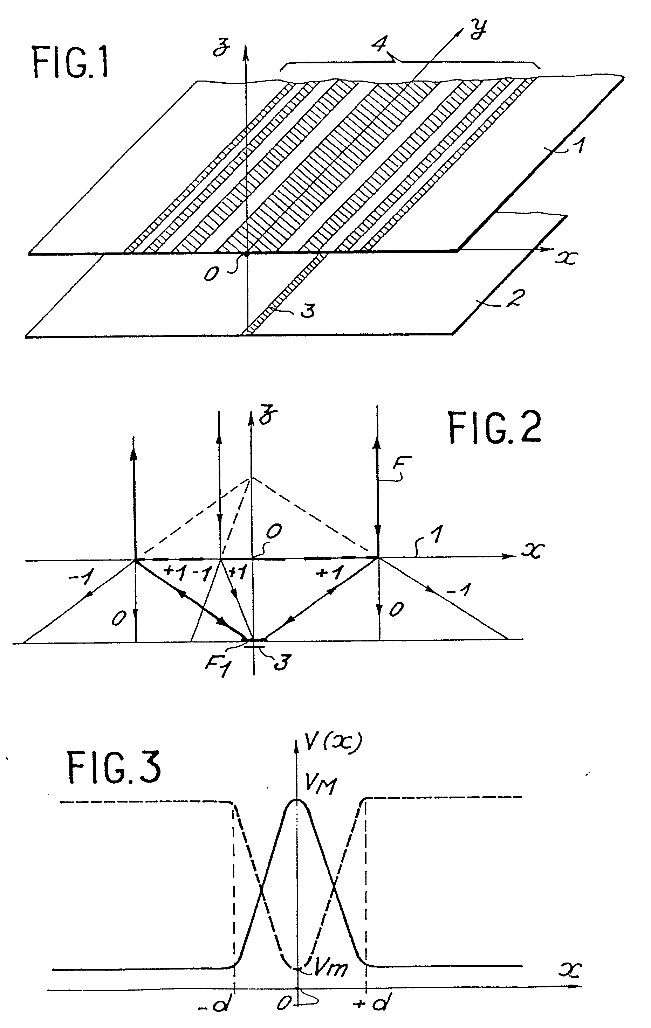

Sur la fig. 1 ont été représentés schématiquement sur un masque 1 et un échantillon 2 les dessins nécessaires à l'alignement. Sur le masque 1 a été inscrite une lentille 4 zones de Fresnel linéaires, formée de bandes d'inégales largeurs, réparties suivant une distribution de Fresnel, alternativement opaques et transparentes.

La bande centrale a été représentée opaque, mais la disposition inverse est également possible. Sur un axe parallèle à la direction d'alignement Ox et perpendiculaire à la direction Oy des bandes, les transitions entre ces bandes ont respectivement pour abscisses $r_n$ tels que:

$$\frac{r^2}{r_n} = nF + \frac{n^2 \lambda^2}{4} \qquad (1)$$

où n est le numéro de la bande, F est la longueur focale souhaitée pour la lentille et $\lambda$ est la longueur d'onde du rayonnement monochromatique éclairant cette lentille. La longueur focale F qui correspond au foyer principal d'ordre 1, $F_1$ de la lentille est choisie égale à la distance séparant les deux plans à aligner, le plan du masque et celui de l'échantillon. Cette distance est de l'ordre d'une dizaine de micromètres. Du fait de l'inégalité des surfaces des bandes (les zones de Fresnel étant linéaires), la contribution des différentes zones au rayonnement diffracté diminue rapidement lorsque l'on s'éloigne de la bande centrale. Par conséquent une lentille formée d'un nombre assez restreint de bandes suffit pour obtenir un rendement correct. A l'extrême, la lentille peut être limitée à une seule zone: la zone centrale.

La fig. 2 montre un schéma, dans le plan xoz, du rayonnement diffracté par une telle lentille éclairée par un faisceau parallèle F. Cette lentille transmet sans la diffracter (ordre 0) une partie du rayonnement et diffracte une autre partie du rayonnement en formant pour une source à l'infini, des images réelles correspondant aux ordres +1, +2, etc. et des images virtuelles correspondant aux ordres −1, −2, etc. Sur la fig. 2, les ordres 0, 1 et −1 ont été représentés. La tache d'éclairement formée sur l'échantillon, lorsque le plan de l'échantillon est à une distance du masque égale à la longueur focale principale (ordre +1) de la lentille, est une bande de largeur approximativement égale à la largeur des bandes extérieures de la lentille à zones de Fresnel. Lorsque le plan de l'échantillon est à une distance supérieure ou inférieure à la longueur focale, l'ordre 1 est encore concentré sur l'échantillon en une tache lumineuse un peu plus large et un peu moins concentrée, mais encore utilisable pour obtenir l'alignement.

Un trait 3 est inscrit sur l'échantillon 2; ce trait est soit plus réfléchissant soit moins réfléchissant que la zone qui l'entoure. Dans les deux cas, le rayonnement réfléchi par le substrat est utilisable pour obtenir l'alignement. Dans le premier cas, le rayonnement réfléchi par le substrat est utilisable pour obtenir l'alignement. Dans le premier cas, le rayonnement réfléchi détecté passe par un maximum lorsque l'ordre 1 diffracté par la lentille à zones de Fresnel linéaires et le trait sont alignés et dans le second cas, le rayonnement réfléchi détecté passe par un minimum.

Pour que l'alignement soit obtenu avec une bonne précision, il est nécessaire que la largeur d, de la tache d'éclairement soit sensiblement égale à la largeur w du trait repère inscrit sur l'échantillon de sorte qu'il existe une position dans laquelle tout le rayonnement concentré dans l'ordre 1 du faisceau diffracté soit réfléchi ou absorbé, et que l'on obtienne un extremum assez contrasté par rapport au rayonnement réfléchi en permanence par l'échantillon.

La fig. 3 représente un exemple de signal détecté V(x) pour w = d, en trait plein lorsque le repère est réflecteur et en traits pointillés lorsque le repère est absorbant, la lentille étant déplacée par rapport au trait repère suivant l'axe Ox, l'extremum est $V_M$ ou $V_m$ selon que le repère est réfléchissant ou absorbant.

Lorsque la distance entre le plan de l'échantillon et le plan du masque varie autour de la longueur focale principale de la lentille, le contraste diminue, mais cette distance n'est pas critique et le réglage peut encore être obtenu. De plus, il est possible d'utiliser les variations du maximum de signal pour effectuer un réglage fin de cette distance à une valeur prédéterminée.

Le rayonnement réfléchi par l'échantillon repasse à travers la lentille à zones de Fresnel et peut être détecté, après séparation par rapport au rayonnement incident effectué par exemple par une lame séparatrice. Mais un tel système conduit à une interaction entre le rayonnement utile et le rayonnement diffracté par le masque.

Pour obtenir une séparation spatiale du rayonnement réfléchi ou diffracté par le masque et du rayonnement de retour émergeant du masque après réflexion sur l'échantillon, plusieurs dispositions peuvent être adoptées.

Ces dispositions sont d'autant plus performantes qu'elles minimisent le fond continu détecté et qu'elles conservent la symétrie du système de manière à réduire l'influence de certains paramètres, comme par exemple l'espacement.

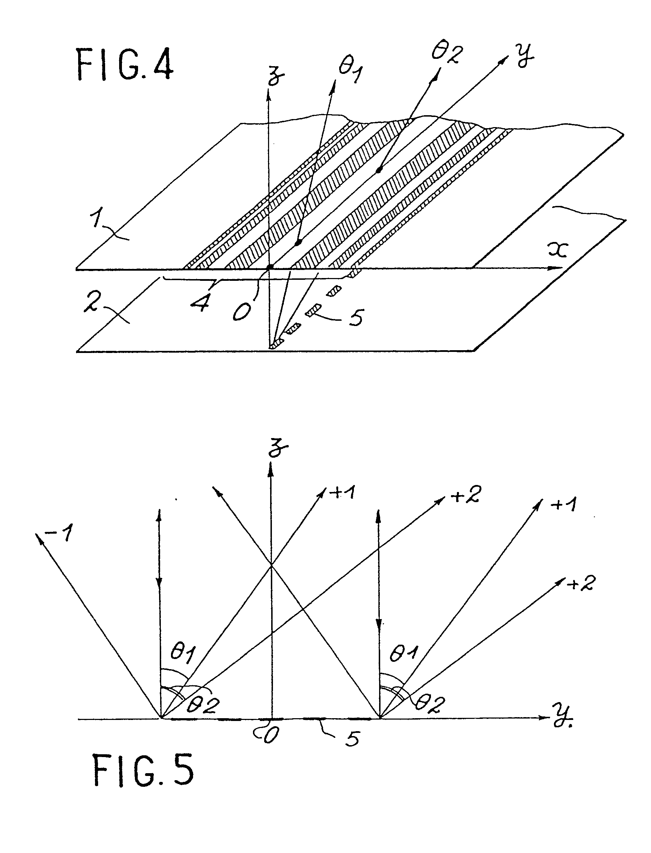

Ces dispositions ont été décrites dans le brevet européen précité et parmi celles-ci l'une des plus avantageuse va être rappelée en relation avec les fig. 4 et 5.

Le dispositif illustré sur la fig. 4 utilise les propriétés de diffraction des réseaux à pas constant. Le trait continu 3 inscrit sur l'échantillon représenté sur la fig. 1, est remplacé sur la fig. 4 par un trait discontinu 5 dans la direction Oy formant un réseau de pas p. Le dispositif fonctionne alors de la manière suivante: le rayonnement parallèle est incident normalement (ou obliquement) sur le masque 1 et forme sur l'échantillon 2 une tache lumineuse rectangulaire allongée dans la direction Oy correspondant à la direction du trait. Le rayonnement ainsi reçu par le trait est réfléchi suivant l'ordre O du réseau formé par le trait et diffracté suivant des directions du plan yoz formant avec l'axe Oz des angles $\theta_n$ tels que $\sin \theta_n = n \frac{\lambda}{p}$, n étant l'ordre de diffraction et $\theta_n$ l'angle de déviation correspondant. Dans chacune de ces directions de diffraction, des moyens de détection permettent de détecter un maximum lorsque la tache lumineuse et le trait interrompu sont alignés; ces directions étant obliques par rapport au faisceau incident, le rayonnement de retour n'interagit pas avec le rayonnement réfléchi par le masque.

La fig. 5 représente le rayonnement diffracté par le trait interrompu 5 dans le plan yoz.

L'ordre +1, diffracté dans le plan yoz est incident obliquement sur la lentille 4 à zones de Fresnel. La source de lumière diffractée étant dans le plan focal de la lentille, le rayonnement émerge de la lentille 4 en un faisceau parallèle oblique par rapport à l'axe de la lentille.

Dans le mode de réalisation représenté sur la fig. 4, le trait interrompu 5 formant un réseau à pas constant p est réalisé sous formes de zones ayant des coefficients de réflexion différents, obtenues par dépôt à travers un masque d'un composé plus (ou moins) réfléchissant que l'échantillon lui-même.

Un réseau réflecteur permettant de dévier le faisceau de retour peut également être réalisé en formant par variation de relief périodique, de profondeur calculée, le long d'une ligne s'étendant dans la direction Oy, un réseau de phase réflecteur.

Les dispositions qui viennent d'être rappelées ne permettent un alignement que selon une seule direction Ox dans l'exemple illustré. Pour obtenir un alignement complet, il est possible d'inscrire sur l'échantillon deux autres lentilles à zones de Fresnel dont les traits sont parallèles à Ox et un trait correspondant sur l'échantillon parallèle à Ox de manière à effectuer l'alignement suivant la direction Oy et l'alignement en rotation.

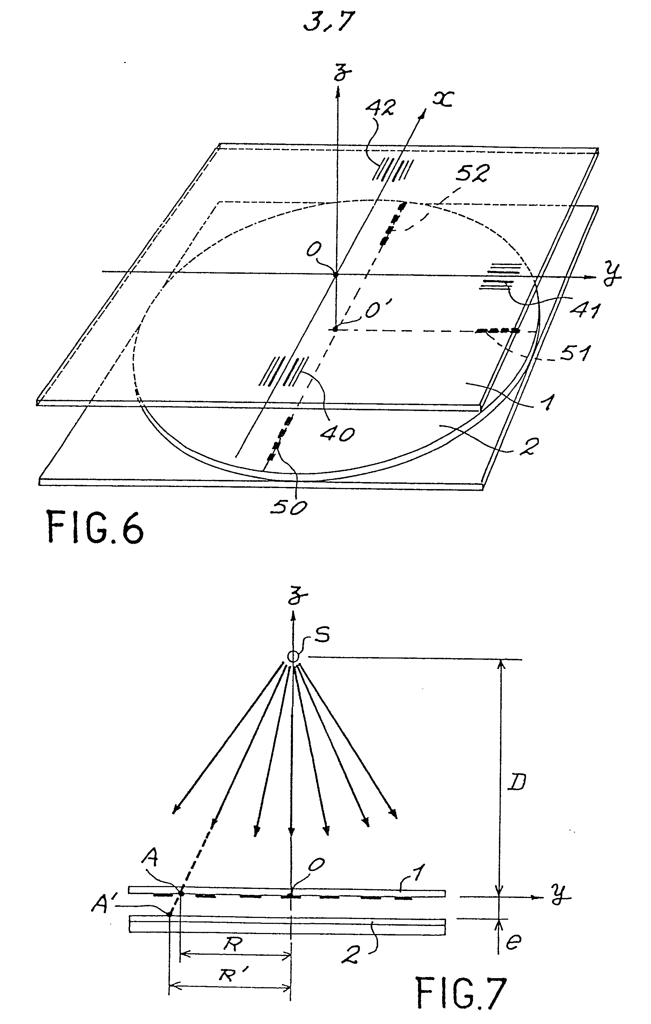

La fig. 6 illustre un ensemble de repères permettant l'alignement complet de l'échantillon 2 par rapport au masque 1.

Dans le plan de l'échantillon il y a trois zones de repère 40, 41 et 42 dans lesquelles ont été inscrites des lentilles à zones de Fresnel.

Dans les zones 40 et 42 les bandes sont parallèles à Ox et dans la zone 41 les bandes sont parallèles à Oy. Cette disposition, dans laquelle les bandes des zones de Fresnel et les traits correspondants sur l'échantillon sont disposés suivant des directions sensiblement radiales, est particulièrement intéressante lorsque l'échantillon est exposé à travers le masque à un rayonnement X car ce rayonnement est légèrement divergent et le motif est légèrement déformé radialement, le positionnement n'étant pas affecté.

Ces trois zones repères permettent un alignement de l'échantillon en x, en y et en rotation autour d'un axe orthogonal aux plans de l'échantillon et du masque.

Cependant pour les raisons qui ont été rappelées, pour des plaquettes et des masques dont le champ utile à recopier à un diamètre correspondant à une résolution supérieure à typiquement $10^5$ points, il n'est plus possible d'assurer un alignement correct de tous les points du champ utile de l'échantillon par rapport au masque.

Les phénomènes physiques qui entrent en jeu vont maintenant être explicités de façon plus détaillée.

Les distorsions dimensionnelles des plaquettes de matériau semi-conducteur et plus particulièrement des plaquettes de silicium ont fait l'objet de nombreuses études pour différents procédés de fabrication de l'art connu, ce aux différents stades de la fabrication de circuits intégrés. A titre d'exemple, il peut être fait référence à l'article de YAU paru dans la revue «Applied Physics Letters», volume 33, n° 8, 15 octobre 1978, pages 756–758. Il apparaît que les principales distorsions sont linéaires et donc correspondent à une expansion ou contraction isotrope du silicium; la partie non linéaire de ces distorsions étant de très faible amplitude et difficilement mesurable.

Dans le cas des distorsions associées au masque, il faut de même distinguer la partie linéaire de ces distorsions qui est également prépondérante par rapport aux distorsions résiduelles non linéaires.

Dans les deux cas les distorsions linéaires observées sont de quelques p.p.m., auxquelles on peut rajouter les distorsions linéaires produites par les variations éventuelles de température: typiquement 2,5 p.p.m. par degré centigrade pour le silicium.

La distorsion linéaire peut être compensée par une variation du grandissement de l'image projetée du masque à condition de contrôler ce grandissement et de pouvoir évaluer la correction de grandissement à apporter.

La reproduction de masques par rayons X en général met en œuvre une source divergente S de rayons X, quasi ponctuelle comme illustré schématiquement par la fig. 7.

Cette source est placée à une distance D d'un masque 1 et une plaquette 2 est séparée par un intervalle e du masque 1. Si A' est l'image d'un point A du masque sur la plaquette, cette image projetée est agrandie d'un facteur:

$$G = \frac{R'}{R} = 1 + \frac{e}{D} \qquad (3)$$

Ce grandissement est toujours supérieur à l'unité. On peut définir une valeur nominale $G_0$ correspondant à un écart $e_0$ nominal et à une distance $D_0$ nominale.

Il est donc possible de contrôler le grandissement en faisant varier soit l'intervalle masque-plaquette e soit la distance source-masque D, soit les deux. Les variations de grandissement $\Delta G_1$ et $\Delta G_2$ obtenues par variation $\Delta e$ de l'intervalle masque-plaquette ou $\Delta D$ de la distance source-masque sont données par les relations suivantes:

$$\Delta G_1 = \frac{\Delta e}{D} \qquad (4)$$

$$\Delta G_2 = (e/D^2)\Delta D \qquad (5)$$

Pour des valeurs typiques de ces paramètres:
D = 400 mm, e = 40 μm, Δe = ±2 μm et ΔD = ±40 mm, on peut obtenir:

$$\Delta G_1 = \pm 5.10^{-6} \qquad (6)$$

$$\Delta G_2 = \pm 10^{-5} \qquad (7)$$

soit des variations de grandissement suffisantes pour permettre la compensation des déformations linéaires habituelles des masques et des plaquettes.

On va maintenant décrire le procédé d'alignement de motifs dans deux plans rapprochés selon l'invention permettant l'évaluation des corrections de grandissement à apporter dans la projection.

En ce qui concerne l'alignement proprement dit, on utilise tel quel le procédé d'alignement décrit dans le brevet européen précité et qui vient d'être rappelé. On utilise au moins trois repères disposés sur l'échantillon comme décrit en relation avec la fig. 6, de préférence du type illustré par la fig. 4; c'est-à-dire consistant en une marque allongée sous forme d'un trait interrompu formant réseau à pas constant.

Cette disposition des repères 40 à 42 et 50 à 52 (fig. 6) permet d'obtenir un centrage automatique des deux plans autour d'un point origine O (sur le plan du masque 1) et de sa projection O' (sur le plan de l'échantillon 2).

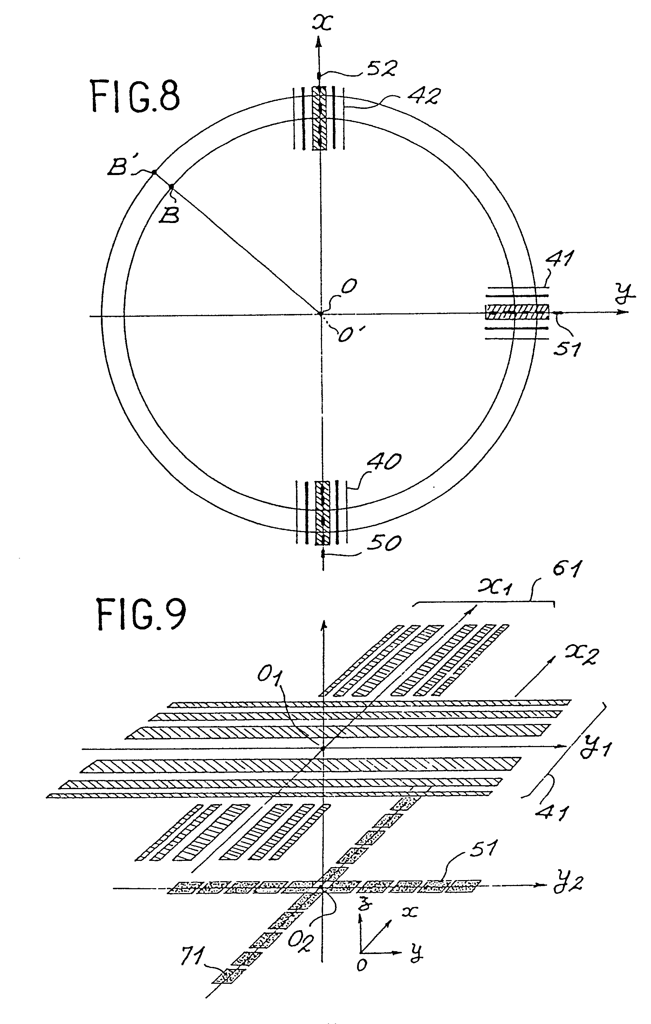

Si le plan de l'échantillon 2 est légèrement agrandi par rapport au plan de masque 1 comme représenté sur la fig. 8, les points O et O' sont alignés, mais un point B' correspondant à un point B situé en périphérie du masque n'est plus aligné.

Le dispositif d'alignement précédemment décrit permet d'obtenir l'alignement automatique très précis (précision de l'ordre de 0,01 $\mu$m) des trois repères d'alignement donc de tous les points des deux plans rapprochés, 1 et 2, si ces deux plans sont rigoureusement superposables. En cas de variation relative d'échelle des deux plans les centres O et O' des deux plans restent rigoureusement alignés mais les écarts de superposition du type BB' (fig. 8) augmentent linéairement avec la distance par rapport au centre. Il est également possible d'aligner angulairement les plans 1 et 2 puisque les traits des repères d'alignement 40 à 42, d'une part, et 50 à 52, d'autre part, sont disposées suivant des directions radiales. Les variations du grandissement $\Delta$G étant de faible amplitude (relation (6)), les taches focalisées, images des lentilles 40 à 42 à zone de Fresnel recouvriront au moins en partie, suivant les directions radiales, les repères 50 à 52 portés sur l'échantillon 2. Il est donc possible de détecter un maximum de signal d'alignement des couples de repères.

Cependant, il faut pouvoir mesurer la variation d'échelle relative des deux plans afin de pouvoir corriger le grandissement de l'image projetée du premier plan 1 de façon à obtenir un alignement rigoureux avec tous les points du deuxième plan 2.

A cette fin, selon un des aspects les plus importants de l'invention, il est fait usage d'au moins deux autres couples de repères ayant les particularités suivantes:

a) les repères sont disposés en périphérie du champ utile comme les repères d'alignement mais leurs traits sont disposés orthogonalement par rapport aux directions radiales.

b) ces repères supplémentaires sont disposés sur deux axes orthogonaux entre eux.

Un premier exemple de réalisation de couples de repères satisfaisant à ces conditions est illustré par la fig. 9. Sur cette figure ont été illustrés les repères correspondant à l'emplacement des repères 41 et 51 sur la fig. 6.

On retrouve d'ailleurs un couple de repères inchangé. Les traits de ces repères 41 et 51 sont alignés sur des axes $y_1$ et $y_2$ respectivement, parallèles à l'axe Oy. Outre ces repères qui servent à l'alignement de la manière rappelée précédemment, il est prévu un couple de repères supplémentaires 61 et 71, respectivement une lentille à zones de Fresnel et un trait interrompu formant réseau à pas constant. Les traits de la lentille à zones de Fresnel et le trait interrompu sont disposés suivant des axes $x_1$, et $x_2$ respectivement, orthogonaux à l'axe Oy et donc aux axes $y_1$ et $y_2$.

La tache, image de la lentille de zone de Fresnel composant le repère 41, focalisée sur le repère 51 produit des ordres de diffraction dans un plan parallèle à l'axe Oy, comme précédemment, et la tache, image de la lentille à zone de Fresnel composant le repère 61, focalisée sur le repère 71, produit des ordres de diffraction dans un plan parallèle à l'axe Ox.

On peut donc détecter et discriminer des signaux correspondant à la superposition des deux couples de repères.

Les premiers signaux servent à aligner angulairement les deux plans 1 et 2 et les seconds signaux à évaluer les distorsions dimensionnelles relatives de ces deux plans. Naturellement comme indiqué précédemment, il faut disposer d'au moins un deuxième couple de repères supplémentaires.

Les repères doivent être disposés sur un axe orthogonal à l'axe Ox par exemple dans la région des repères d'alignement 40 et 50.

Pour augmenter les possibilités de discrimination entre les voies d'alignement et d'évaluation de la distorsion dimensionnelle, il est possible de doter les réseaux formant les repères 51 et 71 de pas différents.

Sur la fig. 9, les deux couples de réseaux sont représentés parfaitement alignés. Leurs centres de symétrie, respectivement $O_1$ et $O_2$ intersection des axes x, y, et $x_2$ $y_2$ sont alors sur un même axe $z_{12}$ parallèle à l'axe Oz.

Cependant, bien que la structure qui vient d'être décrite et que l'on peut qualifier de composite présente l'avantage de pouvoir utiliser en partie des moyens d'illumination et de détection communs aux deux voies d'alignement et d'évaluation de la distorsion dimensionnelle, il y a un risque d'interférence entre les signaux utiles et des signaux parasites dues à des ordres de diffractions produits par les lentilles à zones de Fresnel. En effet, si le réseau du repère 71 produit des ordres de diffractions dans un plan parallèle au plan zOx, la lentille à zones de Fresnel 41 produit pour sa part également des ordres de diffraction parasites dans ce plan qui, même s'il sont de faible amplitude, risque de brouiller les premiers ordres de diffraction, seuls utiles. Il en est de même pour la voie d'alignement.

Aussi pour éliminer tout couplage, dans une variante préférée de l'invention les couples de repères supplémentaires sont disposés sur des axes naturellement orthogonaux entre eux mais distincts des axes sur lesquels sont disposés les couples de repères 40-50, 41-51 et 42-52 servant à l'alignement. De façon optimale, ces axes forment un angle de $\pi/4$ radians avec les axes sur lesquels sont disposés les repères d'alignement.

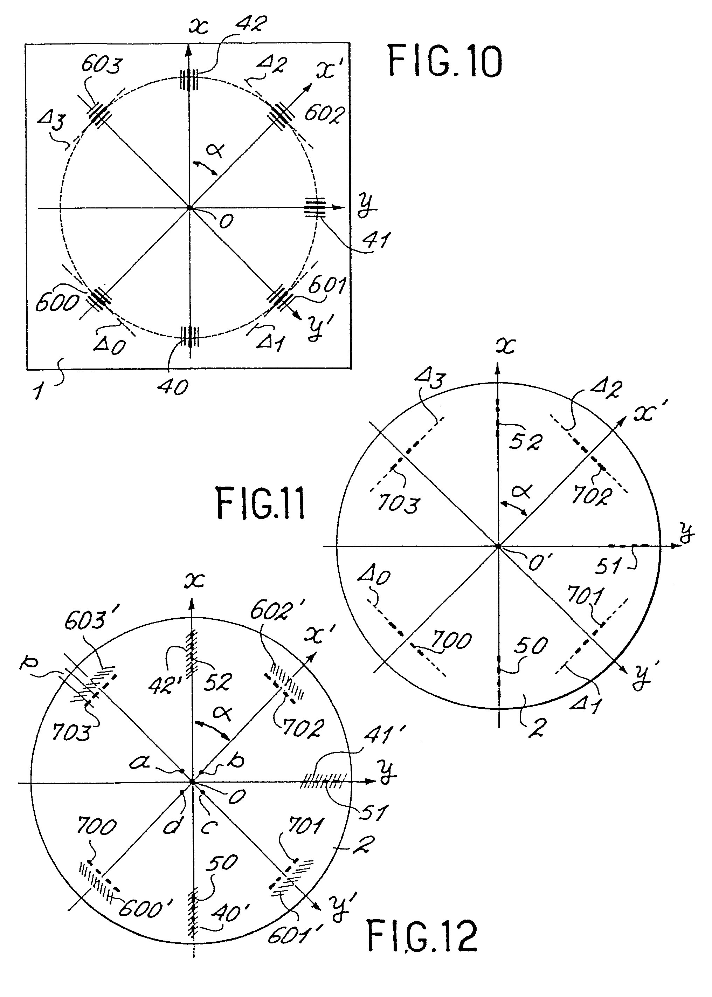

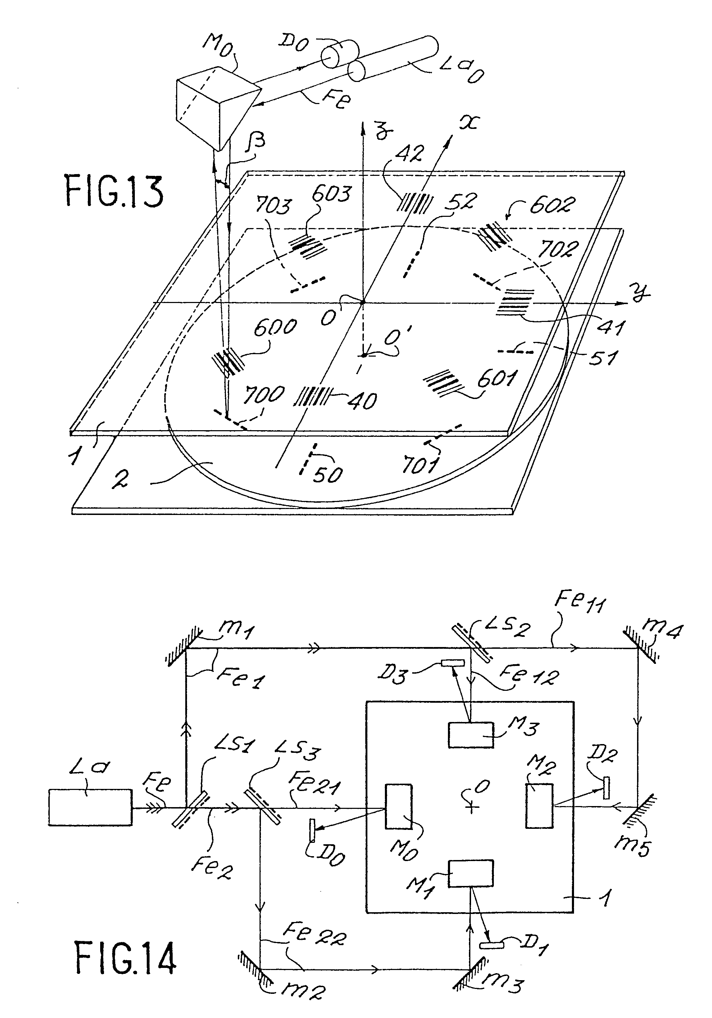

Les fig. 10 et 11 illustrent cette disposition. Sur la fig. 10 sont représentés les repères portés par le masque 1 et sur la fig. 11 les repères correspondant portés par l'échantillon 2.

En outre, comme illustré et pour des raisons qui seront explicités ultérieurement, il est préférable d'utiliser quatre couples de repères supplémentaires au lieu de deux.

Les repères d'alignement, disposés sur un cercle de centre O (masque) ou O' (échantillon) centre de gravité du motif à reproduire, et alignés sur deux axes orthogonaux, sont identiques à ceux décrits précédemment et ont les mêmes fonctions. Ils portent les mêmes références: 40 à 42 pour le masque 1 (fig. 10) et 50 à 52 pour l'échantillon 2 (fig. 11).

Dans cet exemple, quatre couples de repères supplémentaires sont prévus: 600 à 603 pour le masque 1 (fig. 10) et 700 à 703 pour l'échantillon 2 (fig. 11). Ces repères sont disposés également sur un cercle de centre O ou O', qui peut avoir le même rayon qui précédemment. Ces repères sont centrés sur deux axes x' et y' orthogonaux entre eux et formant de préférence un angle $\alpha$ de $\pi/4$ radians avec les axes de référence x et y. Les traits de ces repères sont alignés suivant des axes $\Delta_0$, $\Delta_1$ et $\Delta_2$, $\Delta_3$ respectivement orthogonaux aux axes x' et y'.

Comme pour la voie alignement, les repères supplémentaires du masque sont des lentilles à zones de Fresnel linéaire de longueur focale égale à l'intervalle nominale masque-plaquette. Chaque lentille, éclairée en incidence normale par un faisceau laser, produit dans son plan focal une tache rectangulaire de lumière focalisée dont on peut effectuer la convolution avec le repère correspondant sur la plaquette 2 pour en détecter la position.

La fig. 12 représente l'échantillon 2, c'est-à-dire la plaquette de semi-conducteur avec ses repères 700 à 703 en forme de trait interrompu formant un réseau de pas constant p dont les différents ordres de diffraction sont donnés par la relation $\sin \theta_n = \frac{n\lambda}{p}$ où n est l'ordre de diffraction et $\lambda$ la longueur d'onde du faisceau laser. On a également représenté sur la fig. 12, en traits hachurés, les taches 600' à 603' de lumière focalisée produites par l'éclairement des repères du masque sur la plaquette que l'on suppose alignée à l'aide des repères et placée à distance correcte du masque 1. Les positions des taches 40' à 42' focalisation des repères 40 à 42 sur les repères 50 à 52 ont également été représentées sur la fig. 12. Dans le cas illustré par la fig. 12, la projection du masque 1 n'est pas au même grandissement que la plaquette 2. La plaquette 2 est supposée contractée par rapport au masque.

Dans le dispositif de mise en œuvre du procédé selon l'invention qui sera décrit ultérieurement des moyens mécaniques ou électromécaniques permettent de déplacer la plaquette 2 par rapport au masque 1 ainsi que de mesurer de façon très précise les déplacements effectués.

Partant de la position alignée pour laquelle il a été fait usage des couples de repères 40-50, 41-51 et 42-52, les indications de positions de la plaquette fournies par des capteurs de position sont mémorisées, c'est-à-dire, les déplacements nécessaires pour aligner tout à tour chacun des quatre couples de repères 600-700, 601-701, 602-702 et 603-703, la mesure d'alignement étant effectuée à l'aide du système optique également décrit ultérieurement et reproduit en quatre exemplaires au voisinage de chaque couple de repères.

Pendant ces opérations, le centre O de la plaquette a été amené successivement en a, b, c et d et les indications de position correspondantes ont été enregistrées. Comme il a été indiqué précédemment deux couples de repères sont suffisants. Cependant, l'utilisation de quatre couples de repères permet d'effectuer des moyennes et d'augmenter la qualité de l'évaluation de la distorsion.

Les mesures de Oa, Ob, Oc et Od permettent d'évaluer la distorsion relative des deux plans 1 et 2 et éventuellement de distinguer entre une composante linéaire et une composante non linéaire. La distorsion linéaire peut être compensée par variation de la distance source-masque: D (fig. 7) d'après la relation (5) tandis que la distorsion non linéaire peut être compensée en partie par un réglage fin approprié de l'assiette d'un des deux plans agissant sur l'intervalle e (fig. 7) masque-plaquette selon la relation (4).

Un exemple de dispositif optique permettant de déterminer l'alignement d'un couple de repères supplémentaires va maintenant être décrit de façon plus détaillée par référence à la fig. 13. Ce dispositif consiste simplement en un laser $La_0$, un miroir $M_0$ réglé de façon à obtenir un angle d'incidence fixe, par exemple $\pi/2$ radians du faisceau laser $F_e$ sur un repère du masque 1, le repère 600 dans l'exemple illustré. Le faisceau laser $F_e$ est focalisé dans le plan focal de ce repère constitué d'une lentille à zones de Fresnel. Lorsque le repère 700 correspondant de la plaquette est éclairé par la tache focale, on observe un signal de retour diffracté d'un angle $\beta = \sin^{-1} (\lambda/p)$, transmis par la zone de Fresnel que l'on peut détecter après nouvelle reflexion sur le miroir $M_0$ à l'aide d'une photodiode $D_0$; $\lambda$ est la longueur d'onde d'émission du laser $L_a$ et p le pas du réseau (repère 600). Ce signal présente un maximum très aigu lorsque les deux repères (600 et 700) sont centrés l'un par rapport à l'autre ce qui permet d'obtenir une précision de l'ordre de quelques centièmes de micromètres. Dans la réalité le dispositif optique est reproduit quatre fois autour du masque. Toutefois, on peut n'utiliser qu'une seule source laser associée à des diviseurs de faisceaux et des miroirs.

La fig. 14 illustre un exemple de réalisation possible. Le faisceau $F_e$ émis par un laser unique est tout d'abord divisé une première fois par une lame semi-transparente $LS_1$ à coefficient de transmission et de réflexion peu différent de 0,5; en deux faisceaux $F_{e1}$ et $F_{e2}$. Le faisceau $F_{e1}$ est à son tour, après réflexion sur un miroir de renvoi $m_1$ redivisé en deux faisceaux $F_{e11}$ et $F_{e12}$ par une deuxième lame semi-transparente $LS_2$ identique à la première lame $LS_1$. Le faisceau $F_{e12}$ frappe un miroir $M_3$ associé au couple de repères 603 et 703, fig. 13, de la manière décrite en relation avec cette figure pour le miroir $M_0$. Le faisceau diffracté en retour est capté après réflexion sur le miroir $M_3$ par une photodiode $D_3$ ou tout organe analogue. Le faisceau $F_{e2}$ est divisé également en deux faisceaux $F_{e21}$ et $F_{e22}$. Le faisceau $F_{e21}$ est réfléchi par un miroir $M_0$ associé au couple de repères 600 et 700. Une photodiode $D_0$ détecte le faisceau diffracté. Le faisceau $F_{e22}$ après réflexion sur des miroirs de renvoi $m_2$ et $m_3$ est réfléchi par le miroir $M_1$ associé au couple de repères 601 et 701. Une photodiode $D_1$ détecte le faisceau diffracté. Enfin le faisceau $F_{e11}$ après réflexion sur des miroirs de renvoi $m_4$ et $m_5$ est réfléchi par le miroir $M_2$ associé au couple de repères 602 et 702. Une photodiode $D_2$ détecte le faisceau diffracté.

Les miroirs $M_0$ à $M_1$ peuvent être réalisés à base de prismes à faces réfléchissantes.

Bien que seulement un peu moins de 25% de l'énergie émise est utilisable pour chaque couple de repères, compte-tenu des divisions successives et pertes diverses, cette structure convient parfaitement car l'énergie nécessaire est faible. A titre d'exemple, un laser hélium-néon émettant sur une longueur d'onde centrée sur 0,6328 micromètres, de puissance 5 mW, est suffisant dans le cadre de l'invention. Des photodiodes appropriées associées à des organes électroniques classiques sont couramment disponibles. Cet aspect ne diffère en rien de l'Art Connu.

Il a été supposé jusqu'à présent que l'angle d'incidence des faisceaux laser est de préférence normal au masque 1 ce qui simplifie les réglages optiques. Dans le cas d'une incidence non normale, le plan d'incidence défini par la normale au masque 1 et la direction incidente doit être parallèle aux longueurs des zones de Fresnel afin de ne pas nécessiter de correction sur la position des repères de la plaquette en fonction de l'angle d'incidence.

Les repères d'alignement (40–50, 41–51 et 42–52) et les repères d'évaluation de distorsions dimensionnelles relatives (600–700, 601–701, 602–702, 603–703) sont inscrits de façon permanente sur la plaquette 2 à la suite d'une opération préliminaire de masquage optique ou électronique avant la première opération de masquage par rayons X, par faisceau électronique ou par faisceau ionique.

Pour fixer les idées, il est utile de résumer le procédé de l'invention. Celui-ci comprend les phases suivantes:

a) alignement du masque 1 par rapport à la plaquette 2 ou l'inverse et disposition de celle-ci et du masque dans deux plans parallèles séparés d'une distance nominale e.

b) évaluation des distorsions dimensionnelles relatives du masque 1 et de la plaquette 2.

c) ajustement de la distance source d'exposition-masque en relation avec l'évaluation effectuée pendant la phase b) de manière à corriger les distorsions dimensionnelles relatives de type linéaire.

d) optionellement, ajustement des assiettes relatives du masque 1 et de la plaquette 2 de manière à corriger les distorsions dimensionnelles relatives de type non linéaire.

Suite à ces phases d'alignement, la phase d'exposition au rayonnement X ou particulaire est réalisée pour reproduire le motif du masque 1.

La phase a) est commune à l'Art Connu, notamment l'Art Connu constitué par le brevet EP-B 0 010 998 précité. Cette phase comprend généralement les étapes suivantes:

– positionnement relatif grossier suivant l'axe OZ, à l'aide d'organe mécanique, de la plaquette 2 et les masques. A la suite de cette étape on arrive à définir l'écart nominal e à environ 1 micromètre par défaut ou par excès.

– prépositionnement visuel des repères d'alignement les uns par rapport aux autres. La précision obtenue selon les deux axes ox et oy est de l'ordre de 0,5 mm par défaut ou par excès.

– alignement suivant les axes ox et oy et alignement angulaire par voie optique en utilisant les couples de repères 40–50, 41–51 et 42–52.

A la fin de cette étape, le masque 1 et la plaquette 2 sont centrées (O et O' confondu) et alignés angulairement (position représentée sur la fig. 12).

– ajustement fin de la distance nominale e, à l'aide également des repères d'alignement. Pendant cette étape l'assiette relative des plans en vis-à-vis du masque 1 et de la plaque 2 est ajustée.

Il ne reste plus alors, conformément à l'invention, qu'à ajuster le grandissement donné par la relation (3) pour tenir compte des distorsions dimensionnelles relatives linéaires. Bien qu'il ait été indiqué dans ce qui précède que la correction s'effectue en ajustant la distance D sourcemasque, il est également possible de jouer sur l'écart e entre le masque 1 et la plaquette 2. Cependant l'amplitude de l'ajustement possible est plus faible et il est préférable en outre, pour la phase d'exposition qui suit les phases d'alignement, de travailler à écart nominal e constant.

Jusqu'à présent il a été admis implicitement que les corrections s'effectuaient de façon «manuelle» en ce sens que de la connaissance des valeurs Oa, Ob, Oc et Od en amplitude et en signe on peut calculer d'une part la moyenne entre ces différentes valeurs et en déduire les corrections à apporter. L'action corrective peut être alors initiée par un opérateur ajustant la distance D (fig. 7) et éventuellement l'assiette relative des deux plans en vis-à-vis.

Cependant tout le processus de correction des distorsions peut être effectué de manière entièrement automatique.

Un appareil mettant en œuvre la technique de transfert par proximité incorporant un dispositif automatique d'alignement et de correction des distorsions dimensionnelles relatives va maintenant être décrit. Pour fixer les idées on se place dans le cadre du transfert à l'aide de rayons X. En outre, la description est limitée aux éléments essentiels à la compréhension de l'invention, l'appareil de transfert en soi sortant du cadre de celle-ci.

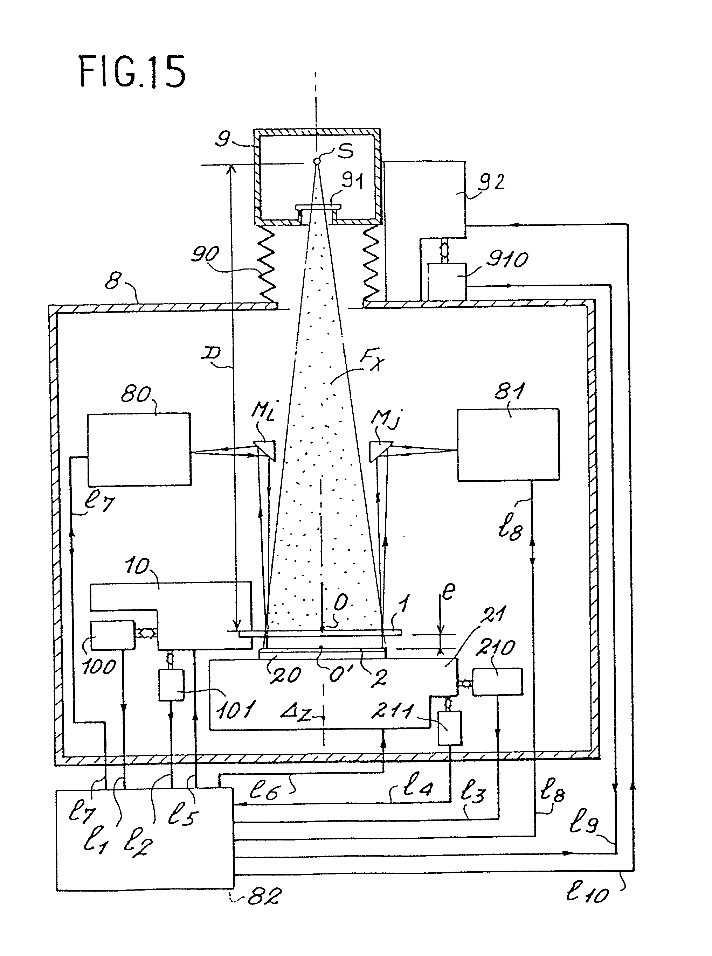

La fig. 15 illustre schématiquement en coupe l'architecture d'un tel appareil de transfert.

L'appareil comporte de façon conventionnelle une enceinte pressurisée 8 dans laquelle règne une basse pression d'hélium, de l'ordre de O.1 at. (98 066,5 Pa).

L'enceinte communique avec un générateur de rayons X par l'intermédiaire d'un soufflet 90. Le générateur de rayon X comporte également une enceinte 9 dans laquelle est disposée une source S de rayons X que l'on peut considérer être quasi-ponctuelle. Cette source S produit un faisceau $F_X$ de rayons X divergent au travers d'une fenêtre 91 pratiquée dans l'enceinte 9, habituellement à base de beryllium.

Dans l'enceinte principale sont disposés tous les éléments conventionnels d'un appareil de transfert.

Il comprend d'abord un organe de prépositionnement 21 de la plaquette 2, disposée habituellement elle-même sur un porte-échantillon 20. L'organe de positionnement permet des mouvements de la plaquette par rapport à un trièdre de référence XYZ (non représenté) lié à l'enceinte principale. Le plan de la plaquette 2 est destiné à être compris, après alignement et réglage de l'assiette dans le plan XY et l'axe Z est alors orthogonal au plan de la plaquette.

De façon conventionnelle, à l'aide de moteurs déplaçant le porte-échantillon 20 suivant deux directions du plan XY et en rotation autour d'un axe parallèle à l'axe Z la plaquette 2 peut être prépositionnée suivant ces deux directions et en rotation autour de l'axe parallèle à l'axe Z.

Enfin, l'assiette du porte-échantillon 20 et donc de la plaquette 2 est ajustée à l'aide d'un tripode non représenté, chaque pied du tripode étant mobile suivant une direction parallèle à l'axe Z.

La position du porte-échantillon 20 et de la plaquette 2 dans l'espace est évaluée à l'aide de deux ensembles de capteurs de position dont deux seulement ont été représentés: un capteur, 210 appartenant à un ensemble de deux capteurs pour évaluer la position de la plaquette par rapport aux deux axes XY, et un capteur de rotation et un capteur 211, appartenant à un ensemble des trois capteurs de position de la plaquette 2 destinés à évaluer l'assiette, c'est-à-dire les positions $Z_1, Z_2, Z_3$ de trois points suivant l'axe Z.

De la même manière, le masque 1 est rendu solidaire d'un organe positionneur permettant l'alignement relatif du masque 1 et de la plaquette 2 à l'aide des couples de repères d'alignement précédemment décrits (fig. 13: 40–50, 41–51 et 42–52) et le réglage de l'intervalle e séparant la plaquette 2 et le masque 1. Pour ce faire, il est également prévu des moyens d'entraînement du masque suivant deux axes orthogonaux du plan XY et des moyens de réglage de sa position suivant l'axe Z et de son assiette autour d'une position moyenne correspondant à l'intervalle nominale e. La position suivant Z et l'assiette sont réglées, comme pour la plaquette, à l'aide d'un tripode mobile permettant de définir trois altitudes $Z'_1, Z'_2, Z'_3$.

Il est également prévu deux ensembles de capteurs de position dont deux ont été représentés: un des capteurs, 100, d'un ensemble de deux capteurs de position du masque 1 suivant deux directions orthogonales du plan XY et un des capteurs, 101, d'un ensemble de trois capteurs de position du masque 1 suivant l'axe Z: position $Z'_1, Z'_2$ et $Z'_3$.

Pour réaliser les opérations d'alignement du masque 1 par rapport à la plaquette 2 il est nécessaire d'éclairer à l'aide d'un faisceau laser, de préférence à incidence orthogonale au masque 1, les repères d'alignement et de détecter les ordres de diffraction de la manière qui a été décrite précédemment. Pour ce faire, il est prévu des moyens 80 opto-électroniques d'émission et de détection d'énergie lumineuse associés à des miroirs de renvoi $M_i$. Ces moyens sont de préférence ceux décrits en relation avec la fig. 9 du brevet européen précité.

Outre les éléments qui viennent d'être rappelés et qui sont communs à l'art connu, l'appareil de transfert comprend en outre des organes plus spécifiques à l'invention. Il comprend tout d'abord des moyens 81 optoélectroniques d'émission et de détection d'énergie lumineuse associés à un jeu de miroirs $M_j$. Dans une variante préférée, ces moyens sont décrits en relation avec la fig. 14 et les miroirs $M_j$ sont au nombre de quatre: $M_0$ à $M_3$, les couples de repères supplémentaires destinés à l'évaluation des distorsions dimensionnelles relatives étant dans cette variante préférée au nombre de quatre: 600–700 à 603–703 (fig. 10, 11 et 13).

En outre des moyens de traitement de données 82, par exemple un microprocesseur associé à des organes habituels d'entrée-sortie de données, de conversion de signaux analogiques en signaux numériques ou l'inverse ainsi que plus généralement d'interface, sont prévus pour piloter en temps réel les différentes phases d'alignement et de correction des distorsions dimensionnelles relatives. A cette fin les moyens de traitement de données 82 reçoivent, par des canaux de transmission $I_1$ à $I_4$ des signaux générés par les différents capteurs de position 100, 101, 210 et 211 qui génèrent sur d'autres canaux de transmission $I_5$ et $I_6$ des signaux de commande des organes de positionnement 10 et 21 du porte-échantillon 20 et du masque 1. Ces signaux de commande sont élaborés à partir des informations de position fournis par les capteurs de position et également, par un canal de transmission supplémentaire $I_7$, des informations fournies par les moyens 80 optoélectroniques d'émission et de détection d'énergie lumineuse. Les moyens de traitement de données fournissent également par l'intermédiaire du canal de transmission $I_7$ des signaux de commande, notamment pour commander l'émission de la source laser utilisée pour l'alignement ainsi que l'énergie électrique nécessaire à cette source. De façon conventionnelle, les moyens de traitement de données 82 comportent des moyens de commande à programme enregistré, par exemple dans une mémoire fixe à lecture seule de type «R.O.M.». Ces dispositions permettent d'exécuter la phase d'alignement du masque 1 par rapport à la plaquette 2 et du réglage de l'écart nominal, phase commune à l'art connu.

Lorsque le masque 1 et la plaquette 2 sont alignés, les points O et O' précédemment définis (fig. 13) sont situés sur un axe $\Delta_z$ (fig. 15) parallèle à l'axe z. Par ajustage préalable de position, la source S est disposée sur cette axe de manière à illuminer symétriquement le masque 1 et la plaquette 2.

Pour exécuter automatiquement les phases ultérieures propres à l'invention, d'évaluation et de correction des distorsions dimensionnelles relatives, un canal de transmission supplémentaire $I_8$ est prévu pour assurer des transmissions de signaux bilatérales entre les moyens de traitement de données 82 et les moyens optoélectroniques 81 d'émission et de détection d'énergie lumineuse utilisés en association avec les couples de repères supplémentaires pour l'évaluation des distorsions dimensionnelles relatives. Les signaux véhiculés sont d'une part des signaux fournis par les photodiodes $D_0$ à $D_3$ (fig. 14) et des signaux de commande de la source laser La (fig. 14). L'énergie électrique nécessaire à l'alimentation de la source laser La est également véhiculée par ce canal.

Les moyens de traitement de données, sous la commande du programme enregistré, génèrent des signaux de commande sur le canal de transmission $I_5$ permettant des déplacements du masque 1 suivant des directions ox' et oy' dans le cas de la variante illustrée par la fig. 12 ou plus généralement dans toutes directions convenables du plan XY de manière à réaliser la séquence de superposition des différents couples de repères utilisés pour l'évaluation des distorsions dimensionnelles relatives. Les signaux générés par les capteurs de positions 100 et 101 permettent de déterminer l'amplitude des distorsions suivant deux axes orthogonaux: $O_a$, $O_b$, $O_c$ et $O_d$ dans l'exemple précité et d'en déduire par des calculs simples les corrections à effectuer sur la distance D séparant les corrections d'assiette de ce masque.

Pour ce faire, l'enceinte 9 contenant la source S de rayon X est solidaire d'un organe 92 de déplacement suivant l'axe Z associé à un capteur de position 910. Les signaux de sortie de ce capteur sont transmis aux moyens de traitement de données 82 par un canal de transmission $I_9$ et un canal supplémentaire $I_{10}$ véhicule des signaux de commande élaborés par les moyens de traitements de données 82 à l'organe de déplacement 92. Ces signaux de commande sont élaborés, sous la conduite du programme enregistré, à partir des informations de position (signaux de sortie du capteur 910) et des données d'évaluation des corrections à effectuer précédemment effectue (phase d'évaluation). Les corrections éventuelles d'assiette, pour tenir compte des distorsions non linéaires sont effectuées en mettant en œuvre à nouveau l'organe 10 de déplacement du masque 1 en transmettant par le canal $I_5$ des signaux de commande de déplacement en altitude: $Z'_1$, $Z'_2$ et $Z'_3$.

En outre, un asservissement des commandes de positionnement peut être réalisé en utilisant en rétroaction les signaux délivrés par les capteurs de positions.

Ces capteurs de position peuvent être de tous types compatibles avec les précisions souhaitées. Pour les organes 10 et 21 de positionnement du masque 1 et de la plaquette 2 on utilise de préférence des interféromètres optiques à compteur de franges, qui en outre présentent l'intérêt de générer des signaux de type numérique plus directement utilisable par un calculateur numérique. Pour l'organe 92 de déplacement de la source rayons X, on peut utiliser un capteur électromécanique. En effet, dans un exemple de réalisation typique, la source S doit pouvoir être déplacée de 40 mm de part et d'autre d'une position moyenne, ce avec une précision de l'ordre de 0,4 mm par excès ou par défaut.

Naturellement les moyens de traitement de données 82 peuvent également être utilisés pour piloter la phase ultérieure d'exposition de la plaquette 2 au travers du masque 1 par le rayonnement X. Cette opération sort du cadre précis de l'invention.

L'invention n'est pas limitée au procédé d'alignement et aux modes de réalisation du dispositif d'alignement précisément décrits. En particulier, pour la réalisation des repères peuvent être mises en œuvres toutes les variantes décrites dans le brevet européen précité et qui n'ont pas été redécrites dans leur totalité.

**Revendications**

1. Procédé d'alignement optique de motifs dans deux plans rapprochés (1, 2) dans un appareil d'exposition comportant une source (S) de rayonnement divergent ($F_x$) disposée à une distance déterminée (D) du premier plan (1); les motifs présentant des distorsions dimensionnelles relatives; procédé comprenant:

– une étape préliminaire d'inscription de trois couples de motifs repères disposés sur deux axes (x, y) orthogonaux et se coupant en un point (O) situé dans une région centrale des motifs à aligner, les motifs repères de chaque couple inscrits sur le premier plan étant formés d'au moins une lentille à zones de Fresnel linéaires (40 à 42) alternativement opaques et transparentes, lesdites zones s'étendant parallèlement à l'axe sur lequel la lentille est disposée, et des motifs repères réfléchissants (50, 52) inscrits sur le second plan et comportant une zone centrale parallèle à l'axe correspondant, la zone centrale de ce motif repère étant en outre gravée pour former un réseau de phase réflecteur de pas constant (p) s'étendant parallèlement à cet axe;

– une étape pendant laquelle les deux plans (1, 2) sont placés parallèlement l'un par rapport à l'autre à un écart (e) déterminé;

– une étape d'alignement suivant lesdits deux axes orthogonaux (x, y) et en rotation autour d'un axe ($\Delta_z$) orthogonal aux deux plans et interceptant la source de rayonnement divergent (S); cette étape d'alignement consistant en des opérations d'éclairements, par un faisceau lumineux monochromatique parallèle, de chaque lentille à zones de Fresnel linéaires (40 à 42) de manière à former dans le second plan un trait lumineux ayant sensiblement les mêmes dimensions que la zone centrale des motifs inscrits sur ce plan, de détection d'une fraction du rayonnement réfléchi par ce second plan et émergeant d'une lentille à zones de Fresnel linéaires, de déplacement de deux plans l'un part rapport à l'autre jusqu'à ce que le rayonnement détecté passe par un extremum correspondant à l'alignement du couple de motifs repères et à répéter ces opérations pour tous les autres couples de motifs repères; ladite source (S) à rayonnement divergent formant sur le second plan l'image du motif du premier plan par ombre projetée avec un grandissement G obéissant à la relation $G = 1 + \frac{e}{D}$, dans laquelle e est l'écart déterminé entre les deux plans et D la distance séparant la source (S) du premier plan (1); caractérisé en ce qu'en outre il comprend:

– une seconde étape préliminaire consistant à inscrire sur deux axes (x', y') orthogonaux se coupant au point d'intersection des axes (x, y) sur lesquels sont inscrits les couples de motifs de repères d'alignement, au moins deux couples de motifs repères supplémentaires (600–700 à 603–703) de nature identique aux repères d'alignement, les motifs repères de chaque couple, s'étendant suivant une direction ($\Delta_0$ à $\Delta_3$) orthogonale auxdits deux axes x', y');

– une étape ultérieure à l'étape d'alignement pour déterminer les distorsions dimensionnelles des deux motifs consistant en des opérations d'éclairement par un faisceau lumineux monochromatique parallèle ($F_e$) de chaque lentille à zones de Fresnel linéaire des couples de motifs repères supplémentaires de manière à former dans le second plan (2) un trait lumineux ayant sensiblement les mêmes dimensions que la zone centrale des motifs (700 à 703) inscrits sur ce plan, de détection d'une fraction du rayonnement réfléchi par ce second plan et émergeant d'une lentille à zones de Fresnel linéaires, de déplacement des deux plans (1, 2) l'un par rapport à l'autre jusqu'à ce que le rayonnement détecté passe par un extremum correspondant à l'alignement du couple de motifs repères (600–700 à 603–703), de mémorisation du déplacement (Oa, Ob, Oc, Od) effectué en signe et en amplitude, à répéter ces opérations pour tous les autres couples de motifs supplémentaires et à déterminer à partir des valeurs de déplacements successifs une grandeur de correction;

– et une étape d'ajustement dudit grandissement G à partir de la grandeur de correction pour obtenir une compensation des distorsions dimensionnelles relatives.

2. Procédé selon la revendication, caractérisé en ce que l'ajustement du grandissement s'effectue en modifiant en amplitude et en signe la distance déterminée (D) séparant la source (S) du premier plan (1); l'écart (e) entre les plans restant constant.

3. Procédé selon la revendication 1, caractérisé en ce que l'ajustement du grandissement s'effectue en modifiant en amplitude et en signe l'écart (e) entre les deux plans, la distance (D) séparant la source (S) du premier plan restant constante.

4. Procédé selon la revendication 1, caractérisé en ce que, les distorsions dimensionnelles relatives comportant une composante à variations linéaires et une composante à variations non linéaires, l'ajustement du grandissement s'effectue en modifiant la distance (D) séparant la source (S) du premier plan (1) pour obtenir une compensation de la composante à variations linéaires et en modifiant l'assiette relative des deux plans (1, 2) pour obtenir une compensation de la composante à variations non linéaires.

5. Procédé selon l'une quelconque des revendications 1 à 4, caractérisé en ce que la seconde étape initiale comprend l'inscription de quatre couples de motifs repères supplémentaires (600–700 à 603–703) répartis symétriquement par rapport au point d'intersection (O) des axes (x', y') les supportant et en ce que ces axes forment un angle de 45° radians avec les axes orthogonaux d'alignement (x, y).

6. Procédé selon l'une quelconque des revendications 1 à 5, caractérisé en ce que le rayonnement est un rayonnement de longueur d'onde compris dans la gamme des rayons X.

7. Dispositif de mise en œuvre du procédé selon l'une quelconque des revendications 1 à 6 dans un appareil comprenant une source (S) de rayonnement divergent pour le transfert par ombre portée d'un motif d'un masque (1) compris dans un premier plan sur un second plan constitué par l'une des faces principales d'un échantillon (2), comprenant des moyens optoélectroniques d'alignement relatif (80, $M_i$) suivant deux directions orthogonales et en rotation autour d'un axe orthogonal aux deux plans à l'aide des couples de motifs repères d'alignement caractérisé en ce qu'il comprend en outre, associés à chacun des couples de motifs repères supplémentaires, une source de lumière monochromatique (La$_0$) et un dispositif de projection du rayonnement de cette source (M$_i$) en un faisceau de rayons parallèles sur le masque (1) dans la zone comprenant la lentille à zones de Fresnel (600 à 603) inscrite sur le masque, et des moyens de détection optoélectroniques (D$_0$ à D$_3$) d'une fraction du rayonnement réfléchi par l'échantillon; et en ce qu'il comprend des moyens de déplacement (10, 20) relatif du masque (1) et de l'échantillon suivant deux directions parallèles aux axes orthogonaux (x', y') supportant les motifs repères supplémentaires, associés à des capteurs (100, 210) de déplacement suivant ces axes délivrant des signaux représentatifs de ces déplacements et des moyens de déplacement (92) de la source (S) de rayonnement divergent suivant un axe orthogonal (Δ$_z$) aux plans du masque (1) et de l'échantillon (2) associés à un capteur de position (910) de la source (S) délivrant des signaux représentatif de la position de celle-ci suivant cet axe (Δ$_z$).

8. Dispositif selon la revendication 7, caractérisé en ce qu'il comprend en outre des moyens pour ajuster l'assiette relative de plans du masque (1) et de l'échantillon (2) associés à des capteurs de déplacement (101) suivant une direction orthogonale aux plans de l'échantillon (2) et du masque (1) délivrant des signaux représentatif des déplacements suivant cette direction.

9. Dispositif selon l'une quelconque des revendications 7 ou 8, caractérisé en ce que les sources de lumières monochromatiques associées à chacun des couples de motifs repères supplémentaires (600-700 à 603-703) sont obtenues à partir du rayonnement d'une source unique (La) émettant un faisceau parallèle (F$_e$) divisé par des lames semi-transparentes (LS$_1$ à LS$_3$) en une succession de faisceaux (F$_{e1}$, F$_{E2}$, F$_{e11}$, F$_{e22}$) dirigés par des miroirs de renvois (m$_1$ à m$_5$) vers lesdits moyens de projections (M$_0$ à M$_3$).

10. Dispositif selon l'une quelconque des revendications 7 à 9, caractérisé en ce qu'il comprend en outre des moyens de traitement de données (82) recevant des signaux de sortie des capteurs des déplacements relatifs du masque et de l'échantillon (100, 101, 210, 211) et de la position (910) de la source (S) et des signaux de sortie des moyens de détection optoélectroniques (81) et en ce que ces moyens de traitements de données (82) comprennent des moyens programmé de détermination à partir de ces signaux de valeurs de correction transmises aux moyens de déplacement (91) de la source (S) et aux moyens de correction d'assiette relatives des plans du masque (1) et de l'échantillon (2) de manière à réaliser une compensation automatique des distorsions dimensionnelles relatives.

## Patentansprüche

1. Optisches Verfahren zur Ausrichtung von Motiven in zwei nahe beieinanderliegenden Ebenen (1, 2), in einem Belichtungsgerät mit einer Quelle (S) divergierender Strahlung (F$_x$), die sich in einem gegebenen Abstand (D) von der ersten Ebene befindet, wobei die Motive relativen Dimensionsveränderungen unterworfen sind und das Verfahren aufweist:

– einen vorbereitenden Verfahrensschritt, in dem drei Paare von Bezugsmotiven aufgezeichnet werden, die auf zwei orthogonalen und sich in einem Punkt (O) schneidenden Achsen (x, y) angeordnet sind, der in einem zentralen Bereich der auszurichtenden Motive liegt, wobei die Bezugsmotive jedes in einer ersten Ebene aufgezeichneten Paars von mindestens einer Linse mit linearen Fresnel-Zonen (40 bis 42) gebildet werden, die abwechselnd strahlenundurchlässig und transparent sind und sich parallel zur Achse erstrekken, auf der die Linse angeordnet ist, während reflektierende Bezugsmotive (50, 52) auf der zweiten Ebene aufgezeichnet sind und eine zur entsprechenden Achse parallele zentrale Zone besitzen, wobei die zentrale Zone dieses Bezugsmotivs ausserdem so graviert ist, dass sie ein Phasenreflektionsnetz mit konstantem Gitterabstand (p) bildet, das sich parallel zu dieser Achse erstreckt;

– einen Verfahrensschritt, während dem die beiden Ebenen (1, 2) in einem gegebenen Abstand (e) parallel zueinander angeordnet werden;

– einen Verfahrensschritt der Ausrichtung gemäss den beiden orthogonalen Achsen (x, y) und gemäss einer Drehung um eine zu den beiden Ebenen senkrechten Achse (Δ$_z$), die die Quelle der divergierenden Strahlung (S) schneidet, wobei dieser Verfahrensschritt besteht: aus der Beleuchtung jeder Linse mit linearen Fresnel-Zonen (40 bis 42) mit einem monochromen parallelen Lichtstrahl, derart, dass in der zweiten Ebene ein Lichtstrich mit im wesentlichen den gleichen Abmessungen wie die zentrale Zone der in dieser Ebene aufgezeichneten Motive gebildet wird; aus der Erfassung eines Teils der von der zweiten Ebene reflektierten und von einer Linse mit linearen Fresnel-Zonen kommenden Strahlung; aus der gegenseitigen Verschiebung der beiden Ebenen zueinander, bis die erfasste Strahlung einen der Ausrichtung des Paars von Bezugsmotiven entsprechenden Extremwert durchläuft, worauf diese Operationen für alle anderen Bezugsmotivpaare wiederholt werden, wobei die Quelle divergierender Strahlung (S) in der zweiten Ebene das Bild des Motivs der ersten Ebene als mit einer Vergrösserung G gemäss der Beziehung B = 1+e/D projizierten Schatten bildet, wobei e der gegebene Abstand zwischen den beiden Ebenen und D der Abstand zwischen der Quelle (S) und der ersten Ebene (1) ist, dadurch gekennzeichnet, dass das Verfahren ausserdem aufweist:

– einen zweiten vorbereitenden Verfahrensschritt, in dem auf zwei orthogonalen und sich im Schnittpunkt der Achsen (x, y), auf denen die Paare von Ausrichtungsbezugsmotiven aufgezeichnet sind, schneidenden orthogonalen Achsen (x', y') mindestens zwei zusätzliche Paare von Bezugsmotiven (600-700 bis 603-703) derselben Art wie die Ausrichtungsbezugsmotive aufgezeichnet werden, wobei die Bezugsmotive jedes Paares sich in einer zu den beiden Achsen (x', y') orthogonalen Richtung ($\Delta_0$ bis $\Delta_3$) erstrecken;

– einen nach dem Ausrichtverfahrensschritt liegenden Verfahrensschritt, um die Dimensionsveränderungen der beiden Motive zu bestimmen, bestehend aus der Beleuchtung jeder Linse mit linearen Fresnel-Zonen der zusätzlichen Bezugsmotivpaare mit einem monochromen parallelen Lichtstrahl ($F_e$) derart, dass in der zweiten Ebene (2) ein Lichtstrich mit im wesentlichen denselben Abmessungen wie die zentrale Zone des in dieser Ebene aufgezeichneten Motivs (700 bis 703) gebildet wird; aus der Erfassung eines Bruchteils der von dieser zweiten Ebene reflektierten und von einer Linse mit linearen Fresnel-Zonen kommenden Strahlung; aus der gegenseitigen Verschiebung der beiden Ebenen (1, 2), bis die erfasste Strahlung einen der Ausrichtung des Bezugsmotivpaars (600–700 bis 603–703) entsprechenden Extremwert durchläuft; aus der Speicherung der Verschiebung (Oa, Ob, Oc, Od) nach Vorzeichen und Amplitude; aus der Wiederholung dieser Operationen für jedes der anderen zusätzlichen Motivpaare und aus der Bestimmung einer Korrekturgrösse aus den aufeinanderfolgenden Verschiebungswerten;

– und einen Verfahrensschritt der Einstellung der Vergrösserung G aufgrund der Korrekturgrösse, um eine Kompensation der relativen Dimensionsveränderung zu erhalten.

2. Verfahren nach Anspruch 1, dadurch gekennzeichnet, dass die Einstellung der Vergrösserung durch Veränderung des bestimmten Abstands (D) zwischen der Quelle (S) und der ersten Ebene (1) nach Amplitude und Vorzeichen erfolgt, während der Abstand (e) zwischen den Ebenen konstant gehalten wird.

3. Verfahren nach Anspruch 1, dadurch gekennzeichnet, dass die Einstellung der Vergrösserung durch Veränderung des Abstands (e) zwischen den Ebenen nach Amplitude und Vorzeichen erfolgt, während der Abstand (D) zwischen der Quelle (S) und der ersten Ebene konstant gehalten wird.

4. Verfahren nach Anspruch 1, dadurch gekennzeichnet, dass in dem Fall, in dem die relativen Dimensionsveränderungen eine lineare und eine nicht-lineare Variationskomponente enthalten, die Einstellung der Vergrösserung durch Veränderung des Abstands (D) zwischen der Quelle (S) und der ersten Ebene (1) erfolgt, um eine Kompensation der linearen Variationskomponente zu erreichen, während die Einstellung der Vergrösserung durch Veränderung der relativen Lage der beiden Ebenen (1, 2) zueinander erhalten wird, um eine Kompensation der nicht-linearen Variationskomponente zu erreichen.

5. Verfahren nach einem beliebigen der Ansprüche 1 bis 4, dadurch gekennzeichnet, dass der zweite ursprüngliche Verfahrensschritt die Aufzeichnung von vier zusätzlichen Bezugsmotivpaaren (600–700 bis 603–703) umfasst, die symmetrisch bezüglich des Schnittpunkts (O) der sie

tragenden Achsen (x', y') verteilt sind, und dass diese Achsen einen Winkel von 45° mit den orthogonalen Ausrichtungsachsen (x, y) einschliessen.

6. Verfahren nach einem beliebigen der Ansprüche 1 bis 5, dadurch gekennzeichnet, dass die Strahlung eine Strahlung einer im Röntgenstrahlungsbereich liegenden Wellenlänge ist.

7. Vorrichtung zur Durchführung des Verfahrens nach einem beliebigen der Ansprüche 1 bis 6 in einem Gerät mit einer Quelle divergierender Strahlung (S) für die Übertragung eines Motivs einer in einer ersten Ebene liegenden Maske (1) durch Schattenwurf in eine zweite Ebene, die von einer der Hauptoberflächen einer Probe (2) gebildet wird, mit optoelektronischen Mitteln zur relativen Ausrichtung (80, $M_i$) gemäss zwei orthogonalen Richtungen und in Drehung um eine zu den beiden Ebenen orthogonale Achse mit Hilfe der Paare von Ausrichtungsbezugsmotiven, dadurch gekennzeichnet, dass die Vorrichtung ausserdem in Zuordnung zu jedem der zusätzlichen Bezugsmotivpaare eine Quelle monochromen Lichts ($La_0$) und eine Vorrichtung zur Projektion der Strahlung dieser Quelle ($M_i$) in Form eines Bündels paralleler Strahlen auf die Maske (1) in der Zone, die die auf der Maske aufgezeichnete Linse mit Fresnel-Zonen (600 bis 603) enthält, und dass die Vorrichtung optoelektronische Mittel ($D_0$ bis $D_3$) zur Erfassung eines Teils der von der Probe reflektierten Strahlung sowie Mittel (10, 20) zur relativen Verschiebung der Maske (1) und der Probe gemäss zwei zu den die zusätzlichen Bezugsmotive tragenden orthogonalen Achsen (x', y') parallelen Richtungen aufweist, wobei diese Mittel Verschiebungsmesssonden (100, 210) gemäss diesen Achsen zugeordnet sind, die für diese Verschiebungen repräsentative Signale liefern, und dass schliesslich Mittel (92) zur Verschiebung der Quelle (S) divergierender Strahlung gemäss einer zu den Ebenen der Maske (1) und der Probe (2) orthogonalen Achse ($\Delta_z$) vorgesehen sind, die einer Sonde (910) für die Lage der Quelle (S) zugeordnet sind, die für die Lage der Quelle bezüglich dieser Achse ($\Delta_z$) repräsentative Signale liefert.

8. Vorrichtung nach Anspruch 7, dadurch gekennzeichnet, dass sie ausserdem Mittel enthält, um die relative Lage der Ebenen der Maske (1) und der Probe (2) einzustellen, die Sonden (101) zugeordnet sind, die die Verschiebung gemäss einer zu den Ebenen der Probe (2) und der Maske (1) senkrechten Richtung messen und für die Verschiebungen gemäss dieser Richtung repräsentative Signale liefern.

9. Vorrichtung nach einem beliebigen der Ansprüche 7 oder 8, dadurch gekennzeichnet, dass die monochromen Lichtquellen, die jedem der zusätzlichen Bezugsmotivpaare (600–700 bis 603–703) zugeordnet sind, ausgehend von einer einzigen Quelle (La) erhalten werden, die einen parallelen Strahl ($F_e$) aussendet, welcher durch halbtransparente Lamellen ($LS_1$ bis $LS_3$) in eine Folge von Bündeln ($F_{e1}$, $F_{E2}$, $F_{e11}$, $F_{e22}$) aufgeteilt wird, welche durch Umlenkspiegel ($m_1$ bis $m_5$) auf

die Projektionsmittel (M$_0$ bis M$_3$) gerichtet werden.

10. Vorrichtung nach einem beliebigen der Ansprüche 7 bis 9, dadurch gekennzeichnet, dass sie ausserdem Datenverarbeitungsmittel (82) aufweist, die Ausgangssignale der Sonden für die relativen Verschiebungen der Maske und der Probe (100, 101, 210, 211) und für die Lage (910) der Quelle (S) sowie Ausgangssignale der optoelektronischen Erfassungsmittel (81) empfängt, und dass diese Datenverarbeitungsmittel (82) programmierte Mittel für die Bestimmung von Korrekturwerten ausgehend von diesen Signalen enthalten, wobei diese Werte an die Mittel (91) zur Verschiebung der Quelle (S) und an die Mittel zur Korrektur der relativen Lage der Maske (1) und der Probe (2) gesandt werden, so dass sich eine automatische Kompensation der relativen Dimensionsveränderungen ergibt.

**Claims**

1. An optical method for aligning patterns according to two planes (1, 2) close to each other in an exposing apparatus comprising a source (S) of diverging radiation (F$_x$) disposed at a predetermined distance (D) from the first plane (1), the patterns being submitted to relative dimensional distorsions, the method comprising:

– a preliminary step during which three pairs of reference patterns are inscribed according to two orthogonal axes (x, y) which intersect at a point (O) situated in the central region of the patterns to be aligned, the reference patterns of each couple inscribed in the first plane being made up of at least one lens having linear Fresnel zones (40 to 42) which are alternately intransparent and transparent, said zones extending parallelly to the axis on which the lens is disposed, whereas reflecting reference patterns (50, 52) are inscribed in the second plane and include a central zone which is parallel to the corresponding axis, the central zone of this reference pattern being further engraved for constituting a reflecting phase network of constant pitch (p) extending parallelly to this axis;
– a step during which the two planes (1, 2) are placed parallelly one with respect to the other at a predetermined distance (e);
– an alignment step along said two orthogonal axes (x, y) and in rotation about an axis (Δ$_z$) which is orthogonal to the two planes and intersects the source (S) of diverging radiation, this alignment step consisting in the operations: of illuminating each lens with linear Fresnel zones (40 to 42) by a monochromatic parallel light bundle in such a way that in the second plane, a light stroke is formed having substantially the same dimensions as the central zone of the patterns inscribed in this plane; of detecting a part of the radiation reflected by said second plane and emerging from a lens with linear Fresnel zones; of mutually displacing the two planes until the detected radiation passes through an extreme value corresponding to the alignment of the couple of reference patterns; and of repeating these operations for all the other couples of reference patterns, said source (S) of diverging radiation generating on the second plane the image of the pattern of the first plane by a projected shadow with an enlargement G responding to the relation G = 1+e/D, in which e is the predetermined distance between the two planes and D the distance between the source (S) and the first plane (1), characterized in that it further comprises:

– a second preliminary step consisting in inscribing, on two orthogonal axes (x', y') which intersect at the point of intersection of the axes (x, y) on which the couples of alignment reference patterns are inscribed, at least two couples of additional reference patterns (600–700 to 603–703) of the same kind as the alignment references, the reference patterns of each couple extending along a direction (Δ$_0$ to Δ$_3$) which is orthogonal to said two axes (x', y');
– a step following the alignment step for determining the dimensional distorsions of the two patterns, consisting in operations: of illuminating the pairs of additional reference patterns with a monochromatic light bundle (F$_e$) parallel to each lens with linear Fresnel zones so as to generate in the second plane (2) a light stroke having substantially the same dimensions as the central zone of the patterns (700 to 703) inscribed in this plane; of detecting a part of the radiation reflected by the second plane and emerging from a lens with linear Fresnel zones; of mutually displacing the two planes (1, 2) until the detected radiation passes through an extreme value corresponding to the alignment of the couple of reference patterns (600–700 to 603–703); of memorizing the performed displacement (Oa, Ob, Oc, Od) by its sign and its amplitude; of repeating these operations for all the other pairs of additional patterns and of determining a correction value in response to the successive displacement values;
– and a step of adjusting said enlargement G in response to the correction value in order to obtain a compensation of the relative dimensional distorsions.

2. A method according to claim 1, characterized in that the adjustment of the enlargement is made by modifying the predetermined distance (D) between the source (S) and the first plane (1) according to amplitude and design, the distance (e) between the planes remaining constant.
3. A method according to claim 1, characterized in that the adjustment of the enlargement is made by modifying the distance (e) between the two planes according to amplitude and to sign, the distance (D) between the source (S) and the first plane remaining constant.
4. A method according to claim 1, characterized in that, the relative dimensional distorsions comprising a component of linear variations and a component of non-linear variations, the adjustment of the enlargement is made by modifying the distance (D) between the source (S) and the first plane in order to obtain a compensation of the component of linear variation and by modifying the relative position of the two planes (1, 2) in order to obtain a compensation of the component of non-linear variation.

5. A method according to any one of claims 1 to 4, characterized in that the second initial step comprises the inscription of four pairs of additional reference patterns (600–700 to 603–703) spaced out symmetrically with respect to the point of intersection (O) of the axes (x', y') on which these patterns are inscribed, and that these axes include an angle of 45° with the orthogonal alignment axes (x, y).

6. A method according to any one of claims 1 to 5, characterized in that the wave length of the radiation is situated in the X-ray range.

7. A device for implementing the method according to any one of claims 1 to 6 in an apparatus including a source (S) of diverging radiation for the transfer of a pattern of a mask (1) situated in the first plane by shadowing on a second plane constituted by one of the principal surfaces of a specimen (2), this device comprising optoelectronic means for relative alignment (80, $M_i$) according to two orthogonal directions and in rotation about an axis which is orthogonal to the two planes, by means of pairs of alignment reference patterns, characterized in that it further comprises, associated to each of the pairs of additional reference patterns, a monochromatic light source ($La_0$) and a device for projecting the radiation of this source ($M_j$) in the form of a bundle of parallel rays onto the mask (1) in the zone comprising the lens with Fresnel zones (600 to 603) inscribed on this mask, and optoelectronic detection means ($D_0$ to $D_3$) for detecting a part of the radiation reflected by the specimen, and that it comprises means (10, 20) for mutually displacing the mask (1) and the specimen according to two directions which are parallel to the orthogonal axes (x', y') supporting the additional reference patterns, associated to sensors (100, 210) for sensing the displacement according to these axes, these sensors supplying signals which are representative for these displacements, and means (92) for displacing the source (S) of diverging radiation according to an axis ($\Delta_z$) orthogonal to the planes of the mask (1) and of the specimen (2), these means being associated to a sensor (910) for sensing the position of the source (S) and for delivering signals which are responsive to the position of the source with respect to said axis ($\Delta_z$).

8. A device according to claim 7, characterized in that it further comprises means for adjusting the relative position of the planes of the mask (1) and of the specimen (2), these means being associated to sensors (101) for sensing the displacement according to a direction orthogonal to the planes of the specimen (2) and of the mask (1), these means supplying signals responsive to the displacements according to this direction.

9. A device according to any one of claims 7 or 8, characterized in that the monochromatic light source associated to each one of the additional reference pattern pairs (600–700 to 603–703) are derived from the radiation of a common source (La) emitting a parallel bundle ($F_e$) which is divided by semi-transparent dices ($LS_1$ to $LS_3$) into a succession of bundles ($F_{e1}$, $F_{E2}$, $F_{e11}$, $F_{e22}$), these bundles being directed by deflection mirrors ($m_1$ to $m_5$) onto the projection means ($M_0$ to $M_3$).

10. A device according to any one of claims 7 to 9, characterized in that it further comprises data processing means (82) receiving output signals from the sensors (100, 101, 210, 211) for the relative displacement of the mask and the specimen and from sensors (910) sensing the position of the source (S) as well as output signals from the optoelectronic detection means (81), and that these data processing means (82) include programmable means for determining correction values in response to the signals, these values being transmitted to the means (91) for displacing the source (S) and to the means for correcting the relative position of the planes of the mask (1) and of the specimen (2) such that an automatic compensation of the relative dimensional distorsions is ensured.

FIG.1

FIG.2

FIG.3

FIG.4

FIG.5

3,7

FIG.6

FIG.7

FIG.8

FIG.9

FIG.10

FIG.11

FIG.12

FIG.13

FIG.14

# FIG.15